# EUROPEAN PATENT APPLICATION

(11) **EP 3 015 567 A1**
(43) Date of publication of application: **04.05.2016**
(21) Application number: 14191169.3
(22) Date of filing: 30.10.2014
(51) Int. Cl.: C23C 18/08, C09D 5/24, C09D 11/52, H01B 1/02, H05K 3/18

(54) **Suppression of the formation of hillocks or crystals when sintering metal-organic silver compounds**

(71) Applicant: Heraeus Deutschland GmbH & Co. KG, 63450 Hanau (DE); Korea Electronics Technology Institute, Gyeonggi-do 463-816 (KR)
(72) Inventor: Fuchs, Herbert, 63549 Ronneburg (DE); Han, Chul Jong, Seoul 135-942 (KR); Lee, Seunghyun, Jeollabuk-do (KR); Lee, Bumjoo, Gyeonggi-do 463-730 (KR)
(74) Representative: Herzog, Fiesser & Partner Patentanwälte PartG mbB

(57) **Abstract**

The present invention relates to a precursor composition comprising
i) at least one metal-organic silver compound,
ii) at least one metal-organic palladium compound,
iii) at least one metal-organic copper compound, and
iv) at least one solvent,
wherein the composition comprises components i), ii) and iii) in such a relative amount that the composition comprises
- at least 90 wt.-% of silver,
- 0.01 to 5 wt.-% of palladium, and
- 0.01 to 5 wt.-% of copper,
in each case based on the total amount of metals in the precursor composition.

The present invention also relates to a process for the production of a layered body, to a layered body obtainable by the process of the present invention, to a layered body comprising a substrate and a metal layer superimposed onto at last a part of at least one surface of the substrate and to a electronic component.

## Description

The present invention relates to a precursor composition, to a process for the production of a layered body, to a layered body obtainable by the process of the present invention, to a layered body comprising a substrate and a metal layer superimposed onto at last a part of at least one surface of the substrate and to a electronic component.

The application of metal layers in the form of coatings in electronic components is well known in the prior art. For example, the electronics, display and energy industries rely on the formation of coatings and patterns of conductive materials to form circuits on organic and inorganic substrates. The primary methods for generating these patterns are screen printing for features larger than about 100 µm and thin film and etching methods for features having a feature size not greater than about 100 µm.

US 6,951,666 B2 discloses a method for the fabrication of a conductive silver layer on a substrate, comprising the steps of providing a precursor composition comprising a metal precursor compound, such as silver trifluoroacetate or silver neodecanoate, depositing said precursor composition on a substrate and heating said precursor composition to form a conductive silver layer. According to the teaching in US 6,951,666 B2 the precursor compositions disclosed therein can be used to prepare electrical interconnects and electrodes for organic light emitting displays (OLEDs). Organic light emitting displays are emissive displays consisting of a transparent substrate coated with a transparent conducting material (e.g., ITO), one or more organic layers and a cathode made by evaporating or sputtering a metal of low work function characteristics. The organic layer materials are chosen so as to provide charge injection and transport from both electrodes into the electroluminescent organic layer (EL), where the charges recombine to emit light. However, it has been observed that if the precursor compositions disclosed in US 6,951,666 B2 are used to prepare electrodes for an OLED, short circuits occur with a high risk of overheating, which often leads to a damage of the OLED-components which interact with the electrode. This causes accelerated aging of some parts of the OLED and considerably shortens its lifetime.

An object of the present invention is thus to reduce or even overcome at least one of the disadvantages of the state of the art.

In particular, it is an object of the present invention to provide a precursor composition that can be used for the formation of electrodes in an OLED, wherein the OLED is characterized by an increased lifetime.

Additionally, it is an object of the present invention to provide a layered body comprising a substrate and a metal layer coated onto the substrate, wherein the metal layer can be used as an electrode in an electronic device such as an OLED and wherein this layered body leads to a reduced occurrence of short circuits and thus to an increased lifetime of the electronic device compared to the electrodes that are obtained when using the precursor compostions known from the prior art.

A contribution to the solution of at least one of the above objects is provided by the subject matter of the category-forming independent claims, wherein the therefrom dependent subclaims represent preferred embodiments of the present invention, whose subject matter likewise make a contribution to solving at least one object.

The invention relates to a precursor composition comprising
i) at least one silver precursor compound,
ii) at least one palladium precursor compound,
iii) at least one copper precursor compound, and
iv) at least one solvent,
wherein the composition comprises components i), ii) and iii) in such a relative amount that the composition comprises
- at least 90 wt.-%, preferably at least 95 wt.-% and most preferably at least 98 wt.-% of silver,
- 0.01 to 5 wt.-%, preferably 0.1 to 2.5 wt.-% and most preferably 0.25 to 1 wt.-% of palladium, and
- 0.01 to 5 wt.-%, preferably 0.1 to 2.5 wt.-% and most preferably 0.25 to 1 wt.-% of copper,
in each case based on the total amount of metals in the precursor composition.

Surprisingly it has been discovered that the addition of a palladium precursor compound and a copper precursor compound in a silver precursor composition as disclosed, for example, in US 6,951,666 B2 leads to a precursor composition, that when being applied in a thin film on a substrate and when subsequently being sintered at a temperature between 100 and 400°C, leads to a silver coating that, compared to a silver coatings prepared with the silver precursor composition known of the prior art, leads to a reduced occurrence of short circuits when being used as an electrode in an electronic device such as an OLED. The precursor composition according to the present invention allows the formation of silver coatings in a mass production using a simple coating process. As the thickness of the silver layers prepared by the precursor composition according to the present invention can be less than 1 µm, these silver coatings can be used to level substrates coated with transparent conductive oxides or conductive polymers. The silver coatings prepared with the precursor composition according to the present invention are, compared to the silver coatings obtained using the compositions disclosed in US 6,951,666 B2, characterized by a reduced amount of hillocks and pinholes.

As used herein, the term "precursor composition" refers to a flowable, preferably a liquid composition that can be treated, such as by heating, to form an electronic feature. The precursor composition can, for example, be an ink or a paste. According to the present invention, the precursor composition is deposited onto a substrate and the viscosity of the composition is typically not critical. The viscosity will, however, affect the type of tool that can be used to deposit the precursor composition. In this regard, the precursor compositions can be formulated to have a high viscosity of at least about 1000 centipoise, such as at least 5000 centipoise. According to one embodiment, the precursor composition has a viscosity of greater than about 10000 centipoise. Such compositions are commonly referred to as pastes. Alternatively, the precursor compositions can be formulated to have a low viscosity, such as not greater than about 1000 centipoise, to enable the deposition of the composition by methods such as ink-jet deposition. Such low viscosity compositions can have a viscosity of not greater than 500 centipoise, preferably not greater than 100 centipoise and even more preferably not greater than 50 centipoise. As used herein, the viscosity is measured under the relevant deposition conditions. For example, some precursor compositions may be heated prior to and/or during deposition to reduce the viscosity.

According to a preferred embodiment of the precursor composition according to the present invention the at least one silver precursor compound i), the at least one palladium precursor compound ii) and the at least one copper precursor compound iii) are a metal-organic silver compound, a metal-organic palladium compound and a metal-organic copper compound, respectively.

The organic component of the metal-organic compound preferably comprises a molecule with at least one, at least two or more carbon atoms, preferably in a range from 2 to 100, or preferably in a range of from 4 to 50, or preferably in a range of from 5 to 20 carbon atoms. According to a preferred embodiment of the organic component of the metal-organic compound this component comprises at least one C=C or at least one C≡C moiety or both.

The organic component preferably also comprises one or two or more non-metal atoms. It is preferred that at least one, two or more non-metal atoms at least coordinate, or preferably form a bond, with the at least one above mentioned metals. The non-metal atoms are preferably selected from the group of oxygen, hydrogen, sulfur, nitrogen, phosphorus, silicon, a halogen and a combination of at least two thereof.

Preferably, the organic component of the metal-organic compound comprises an organic moiety wherein the non-metal atoms or the at least one C=C or the at least one C≡C moiety or both build at least one organic molecule together with the at least one, two or more carbon atom.

According to the invention, the organic moiety may comprise a C=O group or a C-O⁻ group. Further to the C=O group, the organic moiety preferably comprises at least two carbon atoms and preferably at least one nonmetal atom as mentioned above.

In a preferred embodiment of the precursor composition according to the present invention the organic moiety of the metal-organic compound is selected from the group consisting of an alkoxide, a carbonate, an oxalate, an ester, a carboxylate, a halogencarboxylate, a hydroxycarboxylate, an acetonate, a ketonate, an acrylate, an alkenylether, an oxime and a mixture of at least two thereof. For example, the organic moiety can be selected from the group consisting of acetate, proprionate, butanoate, ethylbutyrate, pivalate, cyclohexanebutyrate, acetylacetonate, ethylhexanoate, hydroxypropionate, trifluoracetate, hexafluor-2,4-pentadionate, neodecanoate and a mixture of at least two thereof.

Suitable silver precursors i) can be selected from the group consisting of silver (I) neodecanoate, silver (I) trifluoroacetate, silver (I) acetate, silver (I) lactate, silver (I) cyclohexanebutyrate, silver (I) carbonate, silver oxalate, silver malonate, silver (I) oxide, silver (I) ethylhexanoate, silver (I) acetylacetonate, silver (I) ethylbutyrate, silver (I) pentafluoropropionate, silver (I) benzoate, silver (I) citrate, silver (I) heptafluorobutyrate, silver (I) salicylate, silver (I) decano-ate, silver (I) glycolate, silver (I) β-ketocarboxylate, such as silver (I) i-butyryl-acetate, silver (I) acetoacetate, silver (I) propionylacetate, silver (I) benzoylacetate, silver (I) α-methylacetoacetate, silver (I) α-ethylacetoacetate and silver (I) carbamates, like silver ethylhexylammonium-2-ethylhexylcarbamate. Also suitable are silver carboxylate amine complexes, like silver acetate ethanolamine, or silver polyethercarboxylates and the substituted analogues of the general formula:

[M⁺] [⁻OOC-CR¹R²-(OCR³R⁴-CR⁵R⁶)_{z}-O-CR⁷R⁸-CR⁹R¹⁰-X-R¹²]

wherein
- M: represents Ag;
- R¹, R²: independently from each other represent hydrogen, a halogen, an alkyl-group or an aryl-group;
- R³ to R¹⁰: independently from each other represent hydrogen, a methyl-group, F or a trifluormethyl-group;
- z: represents an integer in the range from 1 to 10
- X: represents O, S or a group NR¹¹, in which R¹¹ represents an alkyl-group, an aryl-group, wherein the alkyl-group and the aryl-group can be substituted;
- R¹²: represents an alkyl-group or an aryl-group, wherein the alkyl-group and the aryl-group can be partially or totally fluorinated.

Suitable palladium precursors ii) can be selected from the group consisting of palladium (II) carboxylates, including palladium (II) fluorocarboxylates such as palladium (II) acetate, palladium (II) propionate, palladium (II) ethylhexanoate, palladium (II) neodecanoate and palladium (II) trifluoroacetate as well as mixed carboxylates such as Pd(II)(OOCH)(OAc), Pd(II)(OAc)(ethylhexanoate), Pd(II)(ethylhexanoate)₂, Pd(II)(OOCH)_{1.5}(ethylhexanoate)_{0.5}, Pd(II)(OOCH)(ethylhexanoate), Pd(II)(OOCCH(OH)CH(OH)COOH)ₘ(ethylhexanoate), Pd(II)(OPr)₂, Pd(II)(OAc)(OPr), palladium (II) oxalate, Pd(II)(OOCCHO)ₘ(OOCCH₂OH)ₙ= (glyoxilic palladium glycolate), palladium (II) alkoxides, palladium (II) β-diketonates such as palladium (II) acetylacetonate or palladium polyethercarboxylates and the substituted analogues of the general formula:

[Mⁿ⁺] [⁻OOC-CR¹R²-(OCR³R⁴-CR⁵R⁶)_{z}-O-CR⁷R⁸-CR⁹R¹⁰-X-R¹²]ₙ

wherein
- M: represents Pd;
- n: represents 2 or 4;
- R¹, R²: independently from each other represent hydrogen, a halogen, an alkyl-group or an aryl-group;
- R³ to R¹⁰: independently from each other represent hydrogen, a methyl-group, F or a trifluormethyl-group;
- z: represents an integer in the range from 1 to 10
- X: represents O, S or a group NR¹¹, in which R¹¹ represents an alkyl-group, an aryl-group, wherein the alkyl-group and the aryl-group can be substituted;
- R¹²: represents an alkyl-group or an aryl-group, wherein the alkyl-group and the aryl-group can be partially or totally fluorinated.

Suitable copper precursors iii) can be selected from the group consisting of copper (II) carboxylates and copper (II) fluorocarboxylates such as copper (II) formate, copper (II) acetate, copper (II) i-butyrate, copper (II) ethylhexanoate, copper (II) neodecanoate, copper (II) methacrylate, copper (II) trifluoroacetate, copper (II) hexanoate, copper (II) β-diketonates such as copper (II) acetylacetonate, copper (II) alkoxides such as copper (II) methoxide or copper (II) t-butoxide, copper (I) pentanoxide, copper (I) methyl-12-pentanoxide, copper (I) formiate or copper formiate compounds of the formula

LₙCu(HCOO) × HCOOH

wherein
- x: represents an integer in the range from 0 to 10
- n: represents an integer in the range from 1 to 4
- L: independently from each other represents a Ligand selected from the group consisting of a phosphine (R¹)(R²)(R³)P, a phosphite (R¹O)(R²O)(R³O)P, an alkene R¹R²C=C³R⁴ or an alkine R¹C=-CR², wherein R¹, R², R³, R⁴ can be hydrogen, an alkyl-group, an aryl-group, an aminoalkyl-group, an alkoxyalkyl-group, a hydroxyalkyl-group, a phosphonoalkyl-group or an aryl-groups, wherein these groups can be partially or totally fluorinated.

Also suitable are copper polyethercarboxylates and the substituted analogues of the general formula:

[Mⁿ⁺] [-OOC-CR¹R²-(OCR³R⁴-CR⁵R⁶)_{z}-O-CR⁷R⁸-CR⁹R¹⁰-X-R¹²]ₙ

wherein
- M: represents Cu;
- n: represents 1 or 2;
- R¹, R²: independently from each other represent hydrogen, a halogen, an alkyl-group or an aryl-group;
- R³ to R¹⁰: independently from each other represent hydrogen, a methyl-group, F or a trifluormethyl-group;
- z: represents an integer in the range from 1 to 10
- X: represents O, S or a group NR¹¹, in which R¹¹ represents an alkyl-group, an aryl-group, wherein the alkyl-group and the aryl-group can be substituted;
- R¹²: represents an alkyl-group or an aryl-group, wherein the alkyl-group and the aryl-group can be partially or totally fluorinated.

Among the foregoing, particularly preferred metal-organic components i), ii) and iii) are selected from the group consisting of an acetylacetonate that may optionally be stabilized with and amine or a phosphine, neodecanoate, ethylhexanoate and a mixture of at least two thereof.

A particularly preferred embodiment of the precursor composition according to the present invention therefore comprises
i) silver (I) acetylacetonate, silver (I) ethylhexanoate or silver (I) neodecanoate or a mixture of at least two thereof, preferably silver (I) ethylhexanoate or silver (I) neodecanoate, and most preferably silver (I) neodecanoate as the silver precursor,
ii) palladium (II) acetylacetonate, palladium (II) ethylhexanoate or palladium (II) neodecanoate or a mixture of at least two thereof, preferably palladium (II) ethylhexanoate or palladium (II) neodecanoate, and most preferably palladium (II) neodecanoate as the palladium precursor,
   and
iii) copper (II) acetylacetonate, copper (II) ethylhexanoate or copper (II) neodecanoate or a mixture of at least two thereof, preferably copper (II) ethylhexanoate or copper (II) neodecanoate, and most preferably copper (II) neodecanoate as the copper precursor.

The precursor composition according to the present invention comprises as component iv) at least one solvent. The selected solvent should be capable of solubilizing the selected metal precursor i), ii) and iii) to a high level. A low solubility of the metal precursors in the solvent leads to low yields of the conductor, thin deposits and low conductivity. According to one embodiment of the precursor composition according to the present invention, the solubility of the metal precursors i), ii) and iii) in the solvent iv) is preferably at least about 20 weight percent metal precursor, more preferably at least 40 weight percent metal precursor, even more preferably at least about 50 weight percent metal precursor and most preferably at least about 60 weight percent metal precursor. Such high levels of metal precursor lead to increased metal yield and the ability to deposit features having adequate thickness. Preferably, the solvent iv) is selected from the group consisting of heptane, hexane, methanol, ethanol, butanol, propanol, acetone, γ-butyrolactone, N-methyl-2-pyrrolidone, acetonitrile, nitromethane, triethylamine, dimethylformamide, dimethylsulfoxide, sulfolane, ethylene carbonate, ethylene glycol monobutyl ether, dimethylcarbonate, propylene glycol methylether acetate, propylene glycol methylether acetate, acetaldehyde oxime, butanone oxime, rosemary oil, lavender or an spike oil, a turpentine oil, a campher oil, a lime oil, texanol, terpineol and a mixture of at least two thereof, wherein the use of terpineol, texanol and turpentine oil is particularly preferred.

The precursor composition according to the present invention may also comprise at least one further additive v) being different from the previously mentioned components i), ii), iii) and iv).

Among these additives v) are reducing agents to prevent the undesirable oxidation of metal species. Reducing agents are materials that are oxidized, thereby causing the reduction of another substance. The reducing agent loses one or more electrons and is referred to as having been oxidized. For example, copper has a strong tendency to oxidize. Precursor compositions according to the present invention can include reducing agents as additives to provide reaction conditions for the formation of the metal at the desired temperature, rather than the metal oxide. Examples of reducing agents include amino alcohols and formic acid.

The precursor composition according to the present invention may also include crystallization inhibitors as the further additive v) and a preferred crystallization inhibitor is lactic acid. Such inhibitors reduce the formation of large crystallites directly from the molecular metal precursor, which can be detrimental to conductivity. Other crystallization inhibitors include ethylcellulose and polymers such as styrene allyl alcohol (SAA) and polyvinyl pyrolydone (PVP). Other compounds useful for inhibiting crystallization are other polyalcohols such as malto dextrin, sodium carboxymethylcellulose and polyoxyethylenephenylether such as TRITON or IGEPAL. In general, solvents with a higher melting point and lower vapor pressure inhibit crystallization of a compound more than a lower melting point solvent with a higher vapor pressure. Preferably, not greater than about 10 wt. % crystallization inhibitor (as a percentage of the total precursor composition) is added, more preferably not greater than 5 wt. % and even more preferably not greater than 2 wt. %.

The precursor composition according to the present invention can also include an adhesion promoter as a further additive v) adapted to improve the adhesion of the conductive metal layer to the underlying substrate. For example, polyamic acid can improve the adhesion of the precursor composition to a polymer substrate. In addition, the precursor composition can include rheology modifiers as a further additive v). As an example, styrene allyl alcohol (SM) can be added to the precursor composition to reduce spreading on the substrate.

The precursor composition according to the present invention can also include a binder as a further additive v) to maintain the shape of the deposited feature. The binder can be, for example, a polymer or in some cases can be a precursor compound. When the precursor composition is deposited onto a flexible substrate, the binder should impart some flexibility to the paste composition or final product in addition to adherence. In some instances, the binder can melt or soften to permit deposition of the precursor composition. According to one embodiment, the binder is a solid at room temperature and when heated to greater than about 50°C, the binder melts and flows allowing for ease of transfer and good wetting of the substrate. Upon cooling to room temperature, the binder becomes solid again maintaining the shape of the electronic feature.

Preferred binders for use in the precursor composition according to the present invention include waxes, styrenic polymers, polyalkylene carbonates, polyvinyl acetals, cellulose based materials, tetradecanol, trimethylolpropane and tetramethylbenzene. The preferred binders have good solubility in a solvent used to formulate the paste composition and should be processable in the melt form. For example, styrene allyl alcohol (SAA) is soluble in dimethyleace-timide, solid at room temperature and becomes fluid-like upon heating to 80°C.

The precursor composition according to the present invention can also include surfactants or dispersants as a further additive v), in particular if the precursor composition comprises particles. Dispersants are added to improve particle dispersion in the vehicle or solvent and reduce inter-particulate attraction within that dispersion. Dispersants are typically two-component structures, namely a polymeric chain and an anchoring group. The anchoring group will lock itself to the particle surface while the polymeric chain prevents agglomeration. It is the particular combination of these, which leads to their effectiveness. The molecular weight of the dispersant is sufficient to provide polymer chains of optimum length to overcome Van der Waals forces of attraction between particles. If the chains are too short, then they will not provide a sufficiently thick barrier to prevent flocculation, which in turn leads to an increase in viscosity. There is generally an optimum chain length over and above which the effectiveness of the stabilizing material ceases to increase. Ideally, the chains should be free to move in the dispersing medium. To achieve this, chains with anchor groups at one end only have shown to be the most effective in providing steric stabilization. An example of a dispersant is SOLSPERSE 21000 (Avecia Limited). For the precursor compositions of the present invention, surfactants should be selected to be compatible with the other components of the composition, particularly the precursor compounds.

It is furthermore preferred that the precursor composition according to the present invention comprises
- 10 to 95 wt.-%, preferably 25 to 80 wt.-% and most preferably 35 to 65 wt.-% of the at least one silver precursor compound i),
- 0.01 to 10 wt.-%, preferably 0.05 to 8 wt.-% and most preferably 0.2 to 5 wt.-% of the at least one palladium precursor compound ii),
- 0.01 to 15 wt.-%, preferably 0.05 to 13 wt.-% and most preferably 0.2 to 10 wt.-% of the at least one copper precursor compound iii),
- at least 10 wt.-%, preferably at least 25 wt.-% and most preferably at least 40 wt.-% of the solvent iv), and
- 0.01 to 5 wt.-%, preferably 0.2 to 3 wt.-% and most preferably 0.4 to 2 wt.-% of the at least one further additive v) being different from components i) to iv),
wherein the total amount of components i) to v) is 100 wt.-%. In some cases solvents employed in the present invention might also coordinate with the metal in the metal-organic compound i), ii) and iii). In these cases the amount on such compound in addition to the amount which coordinates with the metal is considered to act as a solvent.

The precursor composition according to the present invention can be prepared by simply dissolving the precursor compounds i), ii) and iii) and optionally the at least one further additive v) in the solvent iv) in any order. It may be advantageous to heat the solvent iv), preferably to a temperature in the range from 30 to 100°C (wherein the maximum temperature will of course be dependent from the boiling point of the solvent) and to dissolve the precursor compounds i), ii) and iii) in the heated solvent. The hot solution can then be filtered and cooled down to room temperature.

The invention also relates to a process for preparing a layered body comprising a substrate and a metal layer superimposed onto at last a part of at least one surface of the substrate, comprising the process steps:
I) providing a substrate;
II) superimposing at least a part of at least one surface of the substrate with the precursor composition according to the present invention;
III) treating the superimposed substrate at a temperature in a range from 100 to 400°C to convert the metal precursor compounds i), ii) and iii) into a metal layer comprising the corresponding metals or an alloy of the corresponding metals or both.

In process step I) of the process according to the present invention a substrate is provided, wherein the substrate may be selected from the group consisting of a glass, a polymer, a ceramic, a paper, a metal oxide and a metal or a combination of at least two thereof. Preferably, the material of the substrate comprises a polymer foil, a ceramic, a glass or a combination of at least two thereof. The glass is preferably selected from the group consisting of soda-lime glass, lead alkali glass, borosilicate glass, aluminosilicate glass, fused silica, non alkaline glass or mixtures of at least two thereof. The polymer of the polymer foil is preferably selected from the group consisting of a polyethylene, a polypropylene, a polystyrene, a polyimide, a polycarbonate and a polyester or a combination of at least two thereof. Preferably, the polymer is selected from the group of a poly (ethylene therephthalate), polyethylene naphthalate, polybis-maleinimid (PBMI), polybenzimidazol (PBI), polyoxadiazobenzimidazol (PBO), polyimidsulfon (PISO) and polymethacrylimid (PMI) or a mixture of at least two thereof. It is preferred that the substrate comprises a polymer in a range of 10 to 100 wt.-%, or preferably in a range of from 20 to 95 wt.-%, or preferably in a range of from 30 to 90 wt.-%.

The substrate can have any form or geometry that is suitable for use in a multi-layer composite precursor. The substrate preferably has the form or geometry of a layer. The thickness of the substrate preferably lies in a range of from 0.1 to 1000 µm, more preferably in a range of from 1 to 500 µmm, or preferably in a range of from 1 to 100 µm. The substrate preferably has an areal extension, defined as the product of the width and the length, in a range of from 0.01 mm² to 1000000 cm², or preferably in a range of from 0.1 mm² to 500000 cm², or preferably in a range of from 1 mm² to 100000 cm². The substrate preferably comprises a first and a second surface. The first and the second surface of the substrate are preferably provided on the areal extension of the substrate. Preferably, the two surfaces are on opposite sides of the substrate, which is particularly preferred if the substrate is a layered structure, such as a plate, a disc or a bar.

According to a particularly preferred embodiment of the process according to the present invention the substrate is selected from the group consisting of
- glass,
- glass superimposed with a transparent conductive oxide (TCO) or with a conductive polymer, wherein in process step II) the precursor composition according to the present invention is superimposed onto at least a part of the surface of the transparent conductive oxide or the conductive polymer;
- a polymer foil; and
- a polymer foil superimposed with a transparent conductive oxide (TCO) or with a conductive polymer, wherein in process step II) the precursor composition according to the present invention is superimposed onto at least a part of the surface of the transparent conductive oxid or the conductive polymer.

Suitable materials for the TCO layer can be any metal oxides including, but not limited to, oxides of Ag, Al, Cu, Cr, Zn, Mo, Wo, Ca, Ti, In, Sn, Ba, Ti or Ni. Preferred materials are oxides of In, in particular indium tin oxide (ITO), Zn, Sn and BaTiO. The TCO layer may be optionally doped with one or more metals selected from Al, Ga, Sb or other materials such as F and the dopants are in an amount of less than 5 wt %, preferably less than 2 wt % on the basis of the total weight of the TCO layer. Examples of the doped metal oxides for the TCO layer include ZnO:Al (AZO), ZnO:Ga (GZO), SnO₂:Sb (ATO), SnO₂:F (FTO) and BaTiO. The thickness of the TCO-layer can be adjusted to arrive at a desirable transparency and resistivity and is preferably 0.1 µm to 3 µm, more preferably 0.3 µm to 0.8 µm.

Suitable conductive polymers are polyacetylenes, polyanilines, polyparaphenylenes, polypyrrols or polythiophenes, in particular conductive polymer layers that have been prepared using PEDOT/PSS-dispersions.

In process step II) at least a part of at least one surface of the substrate is superimposed with the precursor composition according to the present invention. In case of a substrate a surface of which is superimposed with a TCO-layer or a conductive polymer as described above the composition according to the present invention is preferably superimposed onto at least a part of the TCO-layer or the conductive polymer layer.

The precursor composition according to the present invention can be superimposed onto at least a part of at least one surface of the substrate by any method the person skilled in the art would use to supply an at least partially fluid component, like the precursor composition according to the present invention, onto a preferably solid substrate. Superimposing is preferably achieved by printing, laying, coating impregnating or dipping or a combination thereof, preferably by printing. According to the invention, at least printing is a form of superimposing at least a part of a surface, wherein the precursor composition according to the present invention is applied via an aid in the form of a device onto the surface of the substrate. This can be achieved by different forms of aids. The precursor composition can, for example, be applied via a nozzle or valve by extruding, spraying or jetting. The precursor composition can be applied by coating e.g. brushing, roller superimposing, dip coating or curtain coating. Alternatively or additionally, the precursor composition can be applied or printed via a roll or a drum. As printing methods, gravure printing via a roll or ink-jet printing through an opening, e.g. a nozzle or valve, as well as the screen printing through a mesh, offset printing, flexo printing, tampon printing and spin coating are well known. During the superimposing process, pressure can be applied to the precursor composition or the substrate. Alternatively, the precursor composition is applied using gravity alone. In case of coating a substantial uniform coverage of a surface is desired. In case of printing, however, a two dimensional pattern is formed in the coverage of a surface.

The nozzle or valve can operate by a piezo element or a pneumatic valve as they are often used for ink-jet printers. These valves have the property of building portions of the applied precursor composition that might preferably be applied under pressure to the surface. The portions of the precursor composition preferably have a volume in a range of from 0.1 to 500 nl, or preferably in a range of from 1 to 100 nl, or preferably in a range of from 10 to 50 nl.

In the gravure printing process, the surface to be superimposed is fed between two rolls which are in contact with each other. One roll is called the impression roll and the other roll is called the gravure roll because the liquid phase comes into contact with it. By guiding the substrate between the contacting rolls with the first surface facing towards the gravure roll, the precursor composition according to the present invention can be transferred to the first surface of the substrate.

In the screen printing process the precursor composition is urged through a mesh onto the surface of the substrate. This can be achieved only by gravity or alternatively or additional by using a squeegee or doctor knife.

With these application or coating methods it is possible to create a pattern of the precursor composition according to the present invention onto the surface of the substrate. Preferably, lines or grids are formed by the superimposing process. The lines can have a width in a range of from 0.01 to 10000 µm, preferably in a range of from 0.05 to 1000 µm, or preferably in a range of from 0.1 to 500 µm. The lines of the grid can lie in the same ranges as mentioned for the lines.

In process step III) of the process according to the present invention the superimposed substrate is treated at a temperature in a range from 100 to 400°C to convert the metal precursor compounds i), ii) and iii) into a metal layer comprising the corresponding metals (i. e. silver, palladium and copper) or an alloy of the corresponding metals or both. The temperature of the conversion of the metal precursor compound into the corresponding metal, also called conversion temperature, is dependent on different factors. The conversion temperature, for example, depends on the composition of the precursor composition. It can also depend on the surrounding conditions, like pressure, humidity or light intensity, which could be IR, synthetic light or daylight. The heating can preferably be established by a method selected from the group consisting of irradiation with electromagnetic waves and convection or a combination thereof. The irradiation can preferably be provided by a lamp, for example by an excimer lamp, flash lamp, UV- or an infrared lamp. The convection can preferably be provided to the precursor composition by a hot fluid, for example hot air or hot liquid. Preferably, the substrate superimposed with the precursor composition is heated in a cabinet that is heated electrically. The fluid in the cabinet can be selected from the group consisting of air, nitrogen gas and inert gas or mixtures of at least two thereof. The liquid phase is preferably heated to a temperature in a range of from 100 to 400°C, or preferably in a range of from 150 to 350°C, or preferably in a range of from 200 to 300°C. The treating time is generally in the range from 1 minute to 120 minutes, preferably 5 minutes to 60 minutes and most preferably 10 minutes to 45 minutes.

By heating the precursor composition according to the present invention to a temperature in these ranges, the metal precursor compounds i), ii) and iii) preferably change their composition. In this context it is particularly preferred that the precursor compounds i), ii) and iii) are converted into a metal layer comprising the corresponding metal (i. e. silver, palladium and copper) or an alloy of the corresponding metals, wherein the converted metal has a content of an organic moiety of less than 10 wt.-%, preferably of less than 8 wt.-%, or preferably of less than 5 wt.-% each based on the total weight of the metal. Occasionally the metal layer can comprise the organic moiety in a range of from 0.1 to 10 wt.-%, or preferably in a range of from 0.1 to 8 wt.-%, or preferably in a range of from 0.1 to 5 wt.-% each based on the total weight of the metal.

After the change of composition, the precursor composition has preferably turned into a metal layer that comprises silver, palladium and copper. In this context it is particularly preferred that the metal layer comprises
- at least 90wt.-%, preferably at least 95 wt.-% and most preferably at least 98 wt.-%, based on the total weight of the metal layer, silver,
- 0.01 to 5 wt.-%, preferably 0.1 to 2.5 wt.-% and most preferably 0.25 to 1 wt.-%, based on the total weight of the metal layer, palladium, and
- 0.01 to 5 wt.-%, preferably 0.1 to 2.5 wt.-% and most preferably 0.25 to 1 wt.-%, based on the total weight of the metal layer, copper.

According to a preferred embodiment of the process according to the present invention the process may further comprise the process step
IV) at least partially superimposing the metal layer obtained in process step III) with a transparent conductive layer, preferably with a transparent conductive oxide (TCO) or a conductive polymer, particularly preferred with a conductive polymer.

Preferred conductive oxides (TCO) and conductive polymers are those oxides and polymers that have been previously mentioned in connection with process step (I).

The invention also related to a layered body obtainable by the process according to the present invention.

The present invention also relates to a layered body comprising a substrate and a metal layer superimposed onto at last a part of at least one surface of the substrate, wherein the metal layer comprises
- at least 90 wt.-%, preferably at least 95 wt.-% and most at least 98 wt.-% of silver,
- 0.01 to 5 wt.-%, preferably 0.1 to 2.5 wt.-% and most preferably 0.25 to 1 wt.-% of palladium, and
- 0.01 to 5 wt.-%, preferably 0.1 to 2.5 wt.-% and most preferably 0.25 to 1 wt.-% of copper,
in each case based on the total weight of the metal layer.

Preferred substrates are those that have already been mentioned in connection with the process according to the present invention.

The metal layer that is superimposed onto at last a part of at least one surface of the substrate preferably has a thickness in the range from 0.01 µm to 100 µm, preferably 0.1 to 10 µm and most preferably in a range from 0.5 to 5 µm. According to a particularly preferred embodiment of the layered body according to the present invention the thickness of the metal layer is below 1 µm. In this context it is also preferred that the metal layer is present in the form of a pattern on the surface of the substrate, in particular in the form of lines or grids. The lines can have a width in a range of from 0.01 to 10000 µm, preferably in a range of from 0.05 to 1000 µm, or preferably in a range of from 0.1 to 500 µm. The lines of the grid can lie in the same ranges as mentioned for the lines.

According to a preferred embodiment of the layered body according to the present invention the metal layer is superimposed with a transparent conductive layer, preferably with a transparent conductive oxide (TCO) or a conductive polymer, particularly preferred with a conductive polymer, wherein preferred conductive oxides (TCO) and conductive polymers are those oxides and polymers that have been previously mentioned in connection with process step (I).

It is also preferred that the metal layer of the layered body obtainable by the process according to the present invention as well as the metal layer of the layered body according to the present invention is characterized by at least one of the following properties:
P1) a surface roughness in a range of 1 nm to 800 nm, preferably in a range of 5 nm to 400 nm and most preferably in a range of 10 nm to 100 nm;
P2) a resistivity in a range of 1 × 10⁻⁶ Ω·cm to 1 × 10⁻³ Ω·cm, preferably in a range of 1.5 x 10⁻⁶ Ω·cm to 1 × 10⁻⁴ Ω·cm and most preferably in a range of 2 × 10⁻⁶ Ω·cm to 1 × 10⁻⁵ Ω·cm;
P3) a maximum hillock-size in a range of 1 nm to 2.5 µm, preferably in a range of 5 nm to 1 µm and most preferably in a range of 10 nm to 500 nm;
P4) a thickness in a range of from 0.01 µm to 3 µm, preferably in a range of 0.05 µm to 2 µm and most preferably in a range of 0.1 µm to 1 µm.

The roughness of the surface of the metal layer can be measured with an atomic force microscope (AFM). The surface resistivities of the metal layer can be measured with a four point probe resistivity measurement. The crystal-size and the thickness of the metal layer can be measured with a scanning electron microscope (SEM). The way of executing these methods is described in the test method section below. Preferred combinations of the above properties are: P1, P2, P3, or P2. P3, P4, or P1, P3, P4, or P1, P2, P4, or P1, P2, P3, or P1, P2, or P2, P3, or P3, P4, or P1, P4, or P2, P4, or P1 P3.

The present invention also related to an electronic component comprising a layered body obtainable by the process according to the present invention or a layered body according to the present invention.

In a preferred embodiment of the electronic component, the electronic component is selected from the group consisting of an Organic Light Emitting Diode (OLED), a liquid crystal display (LCDs), a transistor, a smart tag, a smart label, a radio frequency identification (RFID) tag a touch screen and a solar cell.

Organic light emitting displays are emissive displays consisting of a transparent substrate superimposed with a transparent conducting material (e.g., ITO), one or more organic layers and a cathode made by evaporating or sputtering a metal of low work function characteristics (e.g., calcium or magnesium). The organic layer materials are chosen so as to provide charge injection and transport from both electrodes into the electroluminescent organic layer (EL), where the charges recombine to emit light. There may be one or more organic hole transport layers (HTL) between the transparent conducting material and the EL, as well as one or more electron injection and transporting layers between the cathode and the EL. The precursor composition according to the present invention enables, for example, the printing of row and column address lines for OLEDs. These lines can be printed with a thickness of about one µm and a line width of 100 µm using ink-jet printing. These data lines can be printed continuously on large substrates with an uninterrupted length of several meters.

The composition according to the present invention can also be used to prepare electrical interconnects and electrodes for liquid crystal displays (LCDs), including passive-matrix and active-matrix. Particular examples of LCDs include twisted nematic (TN), supertwisted nematic (STN), double supertwisted nematic (DSTN), retardation film supertwisted nematic (RFSTN), ferroelectric (FLCD), guest-host (GHLCD), polymer-dispersed (PD), polymer network (PN).

The composition according to the present invention can also be used prepare electrical interconnects and electrodes in transistors. Thin film transistors (TFTs) are well known in the art, and are of considerable commercial importance. Amorphous silicon-based thin film transistors are used in active matrix liquid crystal displays. One advantage of thin film transistors is that they are inexpensive to make, both in terms of the materials and the techniques used to make them. In addition to making the individual TFTs as inexpensively as possible, it is also desirable to inexpensively make the integrated circuit devices that utilize TFTs. Accordingly, inexpensive methods for fabricating integrated circuits with TFTs, such as those of the present invention, are an enabling technology for printed logic. Organic thin film transistors (TFTs) are expected to become key components in the plastic circuitry used in display drivers of portable computers and pagers, and memory elements of transaction cards and identification tags. A typical organic TFT circuit contains a source electrode, a drain electrode, a gate electrode, a gate dielectric, an interlayer dielectric, electrical interconnects, a substrate, and semiconductor material. The precursor composition of the present invention can be used to deposit all the components of this circuit, with the exception of the semiconductor material. One of the most significant factors in bringing organic TFT circuits into commercial use is the ability to deposit all the components on a substrate quickly, easily and inexpensively as compared with silicon technology (i.e., by reel-to-reel printing). The precursor composition of the present invention enables the use of low cost deposition techniques, such as ink-jet printing, for depositing these components.

The precursor compositions of the present invention is also useful for the direct printing of electrical connectors as well as antennae of smart tags, smart labels, and a wide range of identification devices such as radio frequency identification (RFID) tags. In a broad sense, the precursor composition according to the present invention can be utilized for electrical connection of semiconductor radio frequency transceiver devices to antenna structures and particularly to radio frequency identification device assemblies. A radio frequency identification device ("RFID") by definition is an automatic identification and data capture system comprising readers and tags. Data is transferred using electric fields or modulated inductive or radiating electromagnetic carriers. RFID devices are becoming more prevalent in such configurations as, for example, smart cards, smart labels, security badges, and livestock tags.

The precursor composition according to the present invention can also be used to prepare a conductive pattern serving as an electronic circuit in a photovoltaic panel. Currently, conventional screen-printing is used in mass scale production of solar cells. Typically, the top contact pattern of a solar cell consists of a set of parallel narrow finger lines and wide collector lines deposited essentially at a right angle to the finger lines on a semiconductor substrate or wafer. Such front contact formation of crystalline solar cells is performed with standard screen-printing techniques. Direct printing of these contacts with the precursor composition according to the present invention provides the advantages of production simplicity, automation, and low production cost.

The above and other features and advantages of the invention will be apparent from the following description, by way of example, of embodiments of the invention with reference to the accompanied drawing. The particular features can be realized here by themselves or several in combination with one another. The invention is not limited to the embodiment examples. The embodiment examples are shown in diagram form in the figures. In this context, the same reference symbols in the individual figures designate elements which are the same or the same in function or correspond to one another with respect to their functions.

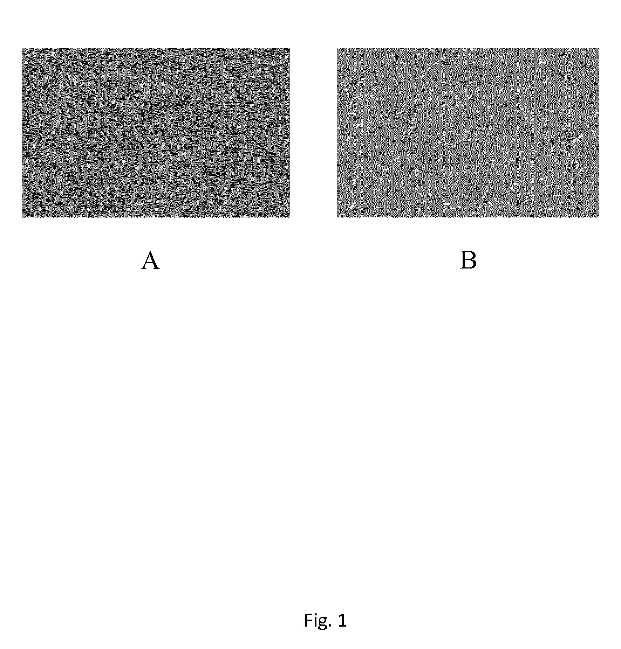

Figure 1 shows the microstructure observed by SEM (5000 x) of the surface of a metal layer prepared using a silver precursor composition solely comprising silver neodecanoate (picture A on the left) and of a metal layer prepared using the precursor composition according to the present invention comprising 24 wt.-% silver, 0.225 wt.-% palladium and 0.424 wt.-% copper, based on the metal content in the composition) (picture B on the right).

### TEST METHODS

### Determination of the surface resistivity

The resistivity is a fundamental property of a material. To measure the resistivity of a layer a rectangular or cubical part of the layer is contacted with two electrical contacts at two opposing ends of the rectangle or cube. By applying a known voltage V [V] to the contacts, measuring the current I [A] and knowing the length L [cm], width W [cm] and thickness T [cm] of the tested part of the layer it is possible to calculate the resistivity R × (T × W)/L indicated in [Ω·cm] by using the Ohm's law R=V/I [ohm]. If not specified otherwise the resistivity has been measured by using copper contacts with a contacting surface of 1 × 1 mm to the opposing ends of the layer to be analysed. A known voltage is applied to the contacts in a range of from 0.01 to 1 V and the current is measured via an amperemeter. The measurement was established at room temperature, normal pressure and a relative humidity of 50 %.

### Determination of the sheet resistance

For measuring the sheet resistance of a multi-layer composite precursor or of a multi-layer composite according to the invention a device "CMT-SR 3000" by the company AiT Co., Ltd. was used. For the measuring 4 point measuring principle is applied. Therefore two outer probes in form of pins apply a constant current and tow inner probes measure the voltage on a rectangular probe. The sheet resistance is deducted by the Ohm's law in Ohm/square by using the equation surface resistance = R × W/L [Ω/sq].

As the sheet resistance can be influenced by the dopant concentration, the resistivity can vary from the outside to the inside of the composite precursor or the composite. To determine the average sheet resistance generally the measurement is performed on 25 equally distributed spots of the composite precursor or composite, wherein the spots all had equal distances to each other.

In an air conditioned room with a temperature of 23 ± 1 °C all equipment and materials are equilibrated to the temperature of 23 °C before the measurement. To perform the measurement the "CMT-SR 3000" is equipped with a 4-point measuring head with sharp tips in order to penetrate layers on the metal layer like an anti-reflection and/or passivation layer. A current of 10 mA is applied to the 4 probes for 3 seconds. The measuring head, incorporating the 4 probes, is brought into contact with the non-metalized wafer material and the measuring of the voltage is started. The voltage is measured by a digital voltmeter (DVM) with a measuring range of 0 V to 2000 mV. After measuring 25 equally distributed spots on the wafer, the average sheet resistance is calculated in Ohm/square.

The pin spacing of the four probes was 0.635 mm ~ 1.27 mm, wherein:
- Pin Load: 10 gram/pin ~ 250 gram/pin, preferably about 20 gram/pin.
- Pin radius: 12.5 µm ~ 500 µm (polished 2 µm diamond), preferably 100 µm
- Tolerance: ± 0.01 mm
- Pin Needles: Solid Tungsten Carbide ϕ0.40 mm

The measuring time was 3 ± 1 sec/point.

### Atomic force microscopy (AFM)

To determine the surface roughness a scanning probe microscope (SPM) of the manufacturer Nanofocus, Korea (model n-Tracer) was utilized. The herewith described method applies for all examples of a AFM scan if not specified otherwise. The optics of the used n-Tracer provides a field of view in a range of 500 µm × 500 µm, a magnification of 500 fold, a resolution of around 1 µm. A white LED light source is used. The dimensions of the probed sample can be in a range of a diameter < 40 mm, a height < 10 mm. The scanner range lies for the x,y-scan in a range of 30 × 30 µm to 80 × 80 µm, and for the z scan range around 6 µm. The surface is normally scanned with the AFM tip at room temperature. The sample loading size was about 100 mm, the x,y-scanner resolution was about 0.1 nm and the z-scanner resolution was ≤ 0.01 nm. Ra (= arithmetic average of absolute values of profile, highest deviation from a mean line) as well as Rms (= Rq = root mean square average of profile height deviations from the mean line) were determined.

### Scanning electron microscopy (SEM)

To establish micrographs of the samples a scanning electron microscopy, a S-4800 II Filed Emission SEM of the company Hitachi High Technology America, Inc. was utilized. The herewith described method applies for all examples of a SEM scan if not specified otherwise. The resolution of the SEM device lies in the range of 1 to 2 nm. The microstructure of the surface is observed by SEM in the magnitude range of × 500 to × 100000.

### EXAMPLES

The raw materials silver (I) neodecanoat, palladium (II) neodecanoat and copper (II) neodecanoate were produced by well-known methods to chemists.

Silver resinate MR 4704-P and palladium resinate A2985 are products of Heraeus, Soligen Cu 8% is a product of OMG-group.

### Comparative Example

61.76 g (184.9 mmol) silver (I) neodecanoate are added in small portions to 44.64 g terpineol and are dissolved at 60 - 70°C by stirring.

The hot solution is filtered through paper filter, type 520 A1/2 from Schleich & Schuell. The filtrate is cooled down to room temperature. The solution was applied to a glass plate and was sintered at 280°C to 300°C for 30 minutes. A smooth silver layer was built, showing numerous hillocks (see figure 1, picture A).

### Example 1

61.76 g (184.9 mmol) silver (I) neodecanoate are added in small portions to 44.64 g terpineol and are dissolved at 60 - 70°C by stirring. After all silver (I) neodecanoate is dissolved, 1.68 g (3.75 mmol) palladium (II) neodecanoate and 1.92 g (4.7 mmol) copper (II) neodecanoate are added and dissolved, too.

The hot solution is filtered through paper filter, type 520 A1/2 from Schleich & Schuell. The filtrate is cooled down to room temperature. The solution was applied to a glass plate and was sintered at 280°C to 300°C for 30 minutes. A smooth silver layer was built, showing no hillocks (see figure 1, picture B).

Roughness comparable example versus example 1:

| | comparative example | example 1 |
|---|---|---|
| Ra | 29.13 nm | 25.0 nm |
| Rms | 36.5 nm | 32 nm |

### Example 2

64.52 g MR 4704-P are dissolved in 28.7 g terpineol and 40 g toluene by stirring. After all solids were dissolved, the solution was filtered through paper filter type 520 A1/2 from Schleich & Schuell. The filtrate is brought into a rotary evaporator and toluene is removed under vacuum at 60 to 70 °C. The concentrated solution is mixed up with 1.5 g of palladium resinate A2985 (15 % Pd) and 5.3 g Soligen Cu 8%.

After applying the solution on a glass plate and sintering the resinate layer at 300 °C for 30 minutes, a smooth silver layer is built, showing no hillocks.

### EMBODIMENTS

I. A precursor composition comprising
   i) at least one silver precursor compound,
   ii) at least one palladium precursor compound,
   iii) at least one copper precursor compound, and
   iv) at least one solvent,
   wherein the composition comprises components i), ii) and iii) in such a relative amount that the composition comprises
   - at least 90 wt.-% of silver,
   - 0.01 to 5 wt.-% of palladium, and
   - 0.01 to 5 wt.-% of copper,
   in each case based on the total amount of metals in the precursor composition.
II. The precursor composition according to embodiment I, wherein the precursor composition is an ink or a paste.
III. The precursor composition according to embodiment I or II, wherein the at least one silver precursor compound i), the at least one palladium precursor compound ii) and the at least one copper precursor compound iii) are a metal-organic silver compound, a metal-organic palladium compound and a metal-organic copper compound, respectively.
IV. The precursor composition according to embodiment III, wherein the organic component of the metal-organic compounds i), ii) and iii) comprises a molecule with at least one carbon atom.
V. The precursor composition according to embodiment IV, wherein the organic component of the metal-organic compounds i), ii) and iii) comprises at least one non-metal atom which at least coordinates with the metal in the metal-organic compound i), ii) and iii).
VI. The precursor composition according to according to embodiment V, wherein the non-metal atom is selected from the group consisting of oxygen, hydrogen, sulfur, nitrogen, phosphorus, silicon, a halogen and a combination of at least two thereof.
VII. The precursor composition according to embodiment IV, wherein the organic component of the metal-organic compounds i), ii) and iii) comprises at least one C=C or C≡C moiety or both.
VIII. The precursor composition according to anyone of embodiments V to VII, wherein the non-metal atoms or the least one C=C or C=C moiety or both build at least one organic molecule together with the at least one carbon atom.
IX. The precursor composition according to embodiment VIII, wherein the organic component of the metal-organic compound i), ii) and iii) comprises a C=O group or a C-O⁻ group.
X. The precursor composition according to embodiment IX, wherein the organic component of the metal-organic compounds i), ii) and iii) is selected from the group consisting of an alkoxide, a carbonate, an oxalate, an ester, a carboxylate, a halogencarboxylate, a hydroxycarboxylate, an acetonate, a ketonate, an acrylate, an alkenylether, an oxime and a mixture of at least two thereof.
XI. The precursor composition according to embodiment X, wherein the organic component of the metal-organic compounds i), ii) and iii) is selected from the group consisting of an acetylacetonate, neodecanoate, ethylhexanoate and a mixture of at least two thereof.
XII. The precursor composition according to anyone of embodiments I to XI, wherein the at least one solvent iv) is selected from the group consisting of heptane, hexane, methanol, ethanol, butanol, propanol, acetone, γ-butyrolactone, N-methyl-2-pyrrolidone, acetonitrile, nitromethane, triethylamine, dimethylformamide, dimethylsulfoxide, sulfolane, ethylene carbonate, ethylene glycol monobutyl ether, dimethylcarbonate, propylene glycol methylether acetate, propylene glycol methylether acetate, acetaldehyde oxime, butanone oxime, rosemary oil, lavender or an spike oil, a turpentine oil, a campher oil, a lime oil, texanol, terpineol and a mixture of at least two thereof.
XIII. The precursor composition according to anyone of embodiments I to XII, wherein the precursor composition comprises
   - 10 to 95 wt.-% of the at least one silver precursor compound i),
   - 0.01 to 10 wt.-% of the at least one palladium precursor compound ii),
   - 0.01 to 15 wt.-% of the at least one copper precursor compound iii),
   - at least 10 wt.-% of the solvent iv), and
   - 0.01 to 3 wt.-% of at least one additive v) being different from components i) to iv),
   wherein total amount of components i) to v) is 100 wt.-%.
XIV. A process for preparing a layered body comprising a substrate and a metal layer superimposed onto at last a part of at least one surface of the substrate, comprising the process steps:
   I) providing a substrate;
   II) superimposing at least a part of at least one surface of the substrate with the precursor composition according to anyone of embodiments I to XII;
   III) treating the superimposed substrate at a temperature in a range from 100 to 400°C to convert the metal precursor compounds i), ii) and iii) into a metal layer comprising the corresponding metals or an alloy of the corresponding metals.
XV. The process according to embodiment XIV, wherein the substrate is selected from the group consisting of a polymer foil, a ceramic, a glass or a combination of at least two thereof.
XVI. The process according to any of the embodiments XIV and XV, wherein the process further comprises process step
   IV) at least partially superimposing the metal layer obtained in process step III) with a transparent conductive layer.
XVII. The process according to embodiment XVI, wherein the transparent conductive layer comprises a conductive polymer.
XVIII. A layered body obtainable by the process according to anyone of embodiments XIV to XVII.
XIX. A layered body comprising a substrate and a metal layer superimposed onto at last a part of at least one surface of the substrate, wherein the metal layer comprises
   - at least 90 wt.-% silver,
   - 0.01 to 5 wt.-% palladium, and
   - 0.01 to 5 wt.-% copper,
   in each case based on the total weight of the metal layer.
XX. The layered body according to anyone of embodiments XVIII and XIX, wherein the metal layer is characterized by at least one of the following properties:
   P1) a surface roughness in a range of 1 nm to 800 nm;
   P2) a resistivity in a range of 1 × 10⁻⁶ Ω·cm to 1 × 10⁻³ Ω·cm;
   P3) a maximum hillock-size in a range of 1 nm to 2.5 µm;
   P4) a thickness in a range of from 0.01 to 3 µm.
XXI. An electronic component comprising a layered body according to anyone of embodiments XVIII to XX.
XXII. The electronic component according to embodiment XXI, wherein the electronic component is selected from the group consisting of an Organic Light Emitting Diode (OLED), a liquid crystal display (LCDs), a transistor, a smart tag, a smart label, a radio frequency identification (RFID) tag a touch screen and a solar cell.

## Claims

1. A precursor composition comprising
i) at least one silver precursor compound,
ii) at least one palladium precursor compound,
iii) at least one copper precursor compound, and
iv) at least one solvent,
wherein the composition comprises components i), ii) and iii) in such a relative amount that the composition comprises
- at least 90 wt.-% of silver,
- 0.01 to 5 wt.-% of palladium, and
- 0.01 to 5 wt.-% of copper,
in each case based on the total amount of metals in the precursor composition.

2. The precursor composition according to claim 1, wherein the precursor composition is an ink or a paste.

3. The precursor composition according to claim 1 or 2, wherein the at least one silver precursor compound i), the at least one palladium precursor compound ii) and the at least one copper precursor compound iii) are a metal-organic silver compound, a metal-organic palladium compound and a metal-organic copper compound, respectively.

4. The precursor composition according to claim 3, wherein the organic component of the metal-organic compounds i), ii) and iii) comprises a molecule with at least one carbon atom.

5. The precursor composition according to claim 4, wherein the organic component of the metal-organic compounds i), ii) and iii) comprises at least one non-metal atom which at least coordinates with the metal in the metal-organic compound i), ii) and iii).

6. The precursor composition according to claim 5, wherein the non-metal atom is selected from the group consisting of oxygen, hydrogen, sulfur, nitrogen, phosphorus, silicon, a halogen and a combination of at least two thereof.

7. The precursor composition according to claim 4, wherein the organic component of the metal-organic compounds i), ii) and iii) comprises at least one C=C or C=C moiety or both.

8. The precursor composition according to anyone of claims 5 to 7, wherein the non-metal atoms or the least one C=C or C=C moiety or both build at least one organic molecule together with the at least one carbon atom.

9. The precursor composition according to claim 8, wherein the organic component of the metal-organic compound i), ii) and iii) comprises a C=O group or a C-O⁻ group.

10. The precursor composition according to claim 9, wherein the organic component of the metal-organic compounds i), ii) and iii) is selected from the group consisting of an alkoxide, a carbonate, an oxalate, an ester, a carboxylate, a halogencarboxylate, a hydroxycarboxylate, an acetonate, a ketonate, an acrylate, an alkenylether, an oxime and a mixture of at least two thereof.

11. The precursor composition according to claim 10, wherein the organic component of the metal-organic compounds i), ii) and iii) is selected from the group consisting of an acetylacetonate, neodecanoate, ethylhexanoate and a mixture of at least two thereof.

12. The precursor composition according to anyone of claims 1 to 11, wherein the at least one solvent iv) is selected from the group consisting of heptane, hexane, methanol, ethanol, butanol, propanol, acetone, γ-butyrolactone, N-methyl-2-pyrrolidone, acetonitrile, nitromethane, triethylamine, dimethylformamide, dimethylsulfoxide, sulfolane, ethylene carbonate, ethylene glycol monobutyl ether, dimethylcarbonate, propylene glycol methylether acetate, propylene glycol methylether acetate, acetaldehyde oxime, butanone oxime, rosemary oil, lavender or an spike oil, a turpentine oil, a campher oil, a lime oil, texanol, terpineol and a mixture of at least two thereof.

13. The precursor composition according to anyone of claims 1 to 12, wherein the precursor composition comprises
- 10 to 95 wt.-% of the at least one silver precursor compound i),
- 0.01 to 10 wt.-% of the at least one palladium precursor compound ii),
- 0.01 to 15 wt.-% of the at least one copper precursor compound iii),
- at least 10 wt.-% of the solvent iv), and
- 0.01 to 3 wt.-% of at least one additive v) being different from components i) to iv),
wherein total amount of components i) to v) is 100 wt.-%.

14. A process for preparing a layered body comprising a substrate and a metal layer superimposed onto at last a part of at least one surface of the substrate, comprising the process steps:
I) providing a substrate;
II) superimposing at least a part of at least one surface of the substrate with the precursor composition according to anyone of claims 1 to 13;
III) treating the superimposed substrate at a temperature in a range from 100 to 400°C to convert the metal precursor compounds i), ii) and iii) into a metal layer comprising the corresponding metals or an alloy of the corresponding metals.

15. The process according to claim 14, wherein the substrate is selected from the group consisting of a polymer foil, a ceramic, a glass or a combination of at least two thereof.

16. The process according to any of the claims 14 or 15, wherein the process further comprises process step
IV) at least partially superimposing the metal layer obtained in process step III) with a transparent conductive layer.

17. The process according to claim 16, wherein the transparent conductive layer comprises a conductive polymer.

18. A layered body obtainable by the process according to anyone of claims 14 to 17.

19. A layered body comprising a substrate and a metal layer superimposed onto at last a part of at least one surface of the substrate, wherein the metal layer comprises
- at least 90 wt.-% silver,
- 0.01 to 5 wt.-% palladium, and
- 0.01 to 5 wt.-% copper,
in each case based on the total weight of the metal layer.

20. The layered body according to anyone of claims 18 and 19, wherein the metal layer is **characterized by** at least one of the following properties:
P1) a surface roughness in a range of 1 nm to 800 nm;
P2) a resistivity in a range of 1 x 10⁻⁶ Ω·cm to 1 × 10⁻³ Ω·cm;
P3) a maximum hillock-size in a range of 1 nm to 2.5 µm;
P4) a thickness in a range of from 0.01 to 3 µm.

21. An electronic component comprising a layered body according to anyone of claims 18 to 20.

22. The electronic component of claim 21, wherein the electronic component is selected from the group consisting of an Organic Light Emitting Diode (OLED), a liquid crystal display (LCDs), a transistor, a smart tag, a smart label, a radio frequency identification (RFID) tag a touch screen and a solar cell.
